**Europäisches Patentamt**

**European Patent Office**

**Office européen des brevets**

(19)

(11) Veröffentlichungsnummer: **0 012 863**
**B1**

(12) **EUROPÄISCHE PATENTSCHRIFT**

(45) Veröffentlichungstag der Patentschrift:
28.07.82

(51) Int. Cl.³: **H 01 L 21/31,** H 01 L 27/04,
G 11 C 11/24

(21) Anmeldenummer: **79104724.4**

(22) Anmeldetag: **27.11.79**

(54) **Verfahren zur Herstellung von Halbleiteranordnungen mit herabgesetzter parasitärer Kapazität.**

(30) Priorität: **26.12.78 US 973219**

(43) Veröffentlichungstag der Anmeldung:
**09.07.80 Patentblatt 80/14**

(45) Bekanntmachung des Hinweises auf die Patenterteilung:
**28.07.82 Patentblatt 82/30**

(84) Benannte Vertragsstaaten:
**DE FR GB**

(56) Entgegenhaltungen:
**DE-A-2 363 466**
**DE-A-2 629 996**
**DE-A-2 637 310**
**FR-A-2 362 493**

**IBM TECHNICAL DISCLOSURE BULLETIN, Band 20, Nr. 11B, April 1978 New York**
**O.S. SPENCER «Smoothing of Irregular SiO2 Surfaces»**
**IBM TECHNICAL DISCLOSURE BULLETIN, Band 19, Nr. 7, Dezember 1976 New York**
**R.R. GARNACHE «Method for Forming Phase Lines»**

(73) Patentinhaber: **International Business Machines Corporation, Armonk, N.Y. 10504 (US)**

(72) Erfinder: **Noble Jr., Wendell Phillips, RFD Nr. 3, Milton, Vermont 05468 (US)**
Erfinder: **Unis, Richard Alan, 4 Old Mill Drive, Poughkeepsie, New York 12603 (US)**

(74) Vertreter: **Kreidler, Eva-Maria, Dr. rer. nat., Schönaicher Strasse 220, D-7030 Böblingen (DE)**

## Verfahren zur Herstellung von Halbleiteranordnungen mit herabgesetzter parasitärer Kapazität

Die Erfindung betrifft ein Verfahren zur Herstellung von Halbleiteranordnungen mit herabgesetzter kapazitiver Kopplung zwischen mindestens einem in einem Halbleitersubstrat angeordneten Dotierungsgebiet und einer isoliert auf dem Substrat vorgesehenen elektrisch leitfähigen Schicht, die über dem Dotierungsgebiet einen grösseren Abstand von der Substratoberfläche als ausserhalb des Dotierungsgebiets und somit eine unebene Oberfläche mit mindestens einem erhabenen Bereich aufweist. Sie bezieht sich insbesondere auf Massnahmen zur Herabsetzung parasitärer Bitleitungskapazitäten in Speicheranordnungen, bei denen die Bitleitungen in Form von Dotierungsgebieten im betreffenden Halbleitersubstrat ausgeführt sind, wobei über dem Substrat mindestens eine elektrisch leitende Schicht vorgesehen ist.

Zum Stand der Technik bezüglich der Herstellung und des Aufbaus von dynamischen MOSFET-Speicheranordnungen unter Einsatz einer aus einem dotierten Oxid bestehenden Diffusionsquellschicht sowie einer leitfähigen Abschirmschicht aus polykristallinem Silicium kann auf die US-Patentschriften 3 811 976 und 3 841 926 in Verbindung mit der weiteren US-Patentschrift 3 387 286 Bezug genommen werden. Dort wird der Aufbau einer Speicherzellenstruktur beschrieben, die mit einem einzigen Transistor sowie einem Kondensator auskommt, wobei eine aus polykristallinem Silicium bestehende Abschirmschicht von der darunter angeordneten diffundierten Bitleitung durch eine relativ dünne dielektrische Schicht aus Siliciumdioxid und Siliciumnitrid beabstandet ist, die das Gate-Dielektrikum des Transistors bildet. Allen Bemühungen zu grösseren Packungsdichten solcher Speicheranordnungen liegt dabei zugrunde, dass eine möglichst kleinflächige Speicherzelle bereitzustellen ist, die ein brauchbares Lesesignal gewisser Mindestgrösse zu liefern in der Lage ist, das durch die Abfühlschaltkreise zuverlässig erkannt und zugeordnet werden kann. Die Grösse eines solchen Lesesignals ist abhängig von der Grösse des Speicherkondensators, den angelegten Spannungen und der Kapazität der Bit-Abfühlleitungen. Auf dem Gebiet solcher Speicheranordnungen kommt dem sog. Übertragungsverhältnis (transfer ratio) als dem Verhältnis der effektiven Kapazität einer Bitleitung zur Kapazität einer einzelnen Speicherzelle im Hinblick auf die Leistungsfähigkeit des Speicherentwurfs besondere Bedeutung zu. Obwohl man vorzugsweise ein geringes Übertragungsverhältnis vorliegen haben möchte, ist es schwierig, die Kapazität der Bit-Abfühlleitung wirksam zu reduzieren. Bei Speicherentwürfen mit einer diffundierten bzw. dotierten Bitleitung beinhalten die parasitäre Bitleitungskapazität einmal die Kapazität des Halbleiterübergangs des die Bitleitung darstellenden Dotierungsgebietes sowie die (Koppel-)Kapazität zwischen der diffundierten Bitleitung und benachbarten isolierten leitfähigen Elektroden. Zur Verringerung dieser parasitären Koppelkapazität zwischen Bitleitung und anderen leitfähigen Schichten oder Schichtbereichen wurden bereits zahlreiche Massnahmen vorgeschlagen. Eine Möglichkeit sieht vor, dass man über solchen diffundierten Bitleitungen relativ dicke (dotierte) Oxidschichten stehen lässt, um so durch Vergrösserung des Abstandes zwischen den Elektroden der wirksamen Kapazität den Kapazitätswert zu verringern. Bei einer anderen Methode wird sorgfältig auf die jeweilige Ätzcharakteristik beim Ätzen der als Diffusionsquellschicht benutzten dotierten Oxidschicht geachtet, um die Überlappungskapazität an den Rändern der diffundierten Bitleitung möglichst gering zu halten, vgl. US-Patentschrift 3 975 220. Hinsichtlich dieser Methode ist jedoch anzumerken, dass davon alle Diffusionen auf dem jeweiligen Halbleiterplättchen betroffen sind und die effektive Reduzierung der Überlappungskapazitäten nur eine kleinen Anteil der bezüglich der Dotierungsbereiche wirksamen gesamten Kapazität ausmacht. Andere Wege zur Verringerung solcher Kapazitäten sehen vor, die leitfähigen Bereiche über solchen Dotierungsgebieten thermisch zu oxidieren (vgl. z.B. IBM Technical Disclosure Bulletin, Juni 1974, Seite 18) oder eine elektrisch nicht leitfähige intrinsische polykristalline Siliciumschicht aufzubiingen, die lediglich in bezüglich der Koppelkapazität unkritischen Bereichen durch Hinzufügen von Dotierungsatomen leitfähig gemacht wird (vgl. IBM Technical Disclosure Bulletin, Juni 1974, Seite 17). Diese Verfahren weisen den Nachteil auf, dass ein zusätzlicher Maskierungs- und Ausrichtungsschritt in einem ohnehin bezüglich der Ausrichtung kritischen Verfahren hinzukommt. Wünschenswert wäre demgegenüber eine Lösung, bei der keine besonderen Anforderungen an die Ausrichtung von Masken gestellt sind, um das Vorkommen grösserer Bereiche einer leitfähigen Schicht, insbesondere über Dotierungsgebieten, auszuschliessen.

Als weiterer Stand der Technik seien ferner die Veröffentlichungen im IBM Technical Disclosure Bulletin, Dezember 1976, Seiten 2471/2472 sowie vom April 1978, Seiten 4842/4843 genannt. In beiden Veröffentlichungen wird eine unregelmässige Oberfläche mit einer Photolackschicht belegt und durch Anwendung einer Ionenimplantation behandelt. Dadurch werden unterschiedliche Ätzraten der so behandelten unregelmässigen Schicht bewirkt, so dass stärker dotierte Bereiche der unregelmässigen Schicht schneller abgetragen werden als die übrigen Bereiche und letztlich eine Planarisierung erzielt wird. Nachteilig bei diesen Verfahren ist, dass das Ätzende solcher auf unterschiedliche Ätzraten angelegten Verfahren prozessmässig schlecht zu kontrollieren ist.

Weiterhin gibt die US-Patentschrift 3 976 524

ein Verfahren zum Herstellen ebener Oberflächen bei integrierten Schaltungen an, bei dem die einzuebnende Oberfläche zunächst mit einer Photolackschicht überzogen wird, die zur Bildung eines Photolackmusters in den vertieften Bereichen nach entsprechender Belichtung und Entwicklung in den erhabenen Bereichen von diesen vollständig und aus den vertieften Bereichen an am Rande belichteten und entwickelten Bereichen entfernt wird. Anschliessend wird das unbelichtete Photolackmuster zum Zerfliessen gebracht, so dass die vertieften Bereiche vollständig maskiert werden. Die erhabenen Bereiche können danach bis auf die Tiefe der vertieften Bereiche abgetragen werden. Schliesslich ist noch die US-Patentschrift 4 070 501 von Interesse, die ein Verfahren zur selbstausrichtenden Herstellung von Mehrlagen-Leitungssystemen mit Querverbindungen betrifft. Dabei wird auf ein ein erstes Leitungsmuster tragendes Substrat eine Isolationsschicht aufgebracht, die der Oberfläche der Topologie des Leitungsmusters entspricht, also entsprechende Erhebungen aufweist. Auf die Isolationsschicht wird eine zweite Schicht aufgebracht, deren Dicke über den Leitungszügen geringer ist als neben diesen. Mittels einer Maske wird im Bereich der zu bildenden Verbindungslöcher über den Leitungszügen das Material der zweiten Schicht über den Erhebungen entfernt. Schliesslich werden die Verbindungslöcher in der Isolationsschicht durch Ätzen gebildet, wobei die Maske und die zweite Schicht als Ätzmaske dienen.

Die Erfindung, wie sie in den Patentansprüchen gekennzeichnet ist, löst die Aufgabe, ein verbessertes Herstellungsverfahren für Halbleiteranordnungen mit verringerten parasitären Kapazitäten anzugeben, die aus dem Zusammenwirken von Dotierungsgebieten in einem Substrat mit darüber angeordneten leitfähigen Schichten bzw. Schichtbereichen resultieren können. Insbesondere soll mit dem Verfahren die Herstellung von kapazitiven Ein-FET-Speicheranordnungen mit reduzierter Bitleitungskapazität möglich sein.

Zusammengefasst sieht die Erfindung zur Herabsetzung der kapazitiven Kopplung zwischen mindestens einem in einem Halbleitersubstrat angeordneten Dotierungsgebiet und einer isoliert auf dem Substrat vorgesehenen elektrisch leitfähigen Schicht, die über dem Dotierungsgebiet einen grösseren Abstand von der Substratoberfläche als ausserhalb des Dotierungsgebiets und somit eine unebene Oberfläche mit mindestens einem erhabenen Bereich aufweist, vor, auf die Oberfläche der leitfähigen Schicht eine relativ dicke Maskierungsschicht, vorzugsweise aus Photolack, derart aufzubringen, dass die leitfähige Schicht mit unregelmässiger Oberfläche vollständig bedeckt wird und sich eine praktisch ebene Oberfläche bildet. Anschliessend wird ein subtraktiver Prozess, z.B. ein Ätz- oder Entwicklungsprozess, ausgeführt, um einen gleichmässigen Schichtanteil der Maskierungsschicht soweit abzutragen, dass bereichsweise die erhabenen Bereiche der Oberfläche der leitfähigen Schicht freigelegt werden. Die leitfähige Schicht wird dann mittels eines weiteren Abtragungsverfahrens, z.B. durch Ätzen, in dem Gebiet über dem Dotierungsgebiet im Halbleitersubstrat entfernt. Damit lassen sich insbesondere über diffundierten Bitleitungen die zugehörigen Bereiche einer eventuell vorgesehenen leitfähigen Schicht entfernen und die Bitleitungskapazitäten wirksam herabsetzen. Der zusätzlich erforderliche photolithographische Schritt ist dabei völlig unkritisch hinsichtlich der letzlich möglichen Packungsdichte, da keine besonderen Anforderungen an eine Ausrichtung oder eine selektive Belichtung gestellt sind.

Die Erfindung wird im folgenden anhand eines Ausführungsbeispiels unter Zuhilfenahme der Zeichnungen näher erläutert.

Es zeigen:

Fig. 1 bis 5 Querschnitte durch eine Halbleiteranordnung für ein dynamisches Speicherelement in verschiedenen anfänglichen Verfahrensstufen, die als typisch für den Stand der Technik angesehen werden können und

Fig. 6 bis 11 entsprechende Querschnittsdarstellungen zur Verdeutlichung nachfolgender Verfahrensschritte im Rahmen der vorliegenden Erfindung.

Im einzelnen zeigen:

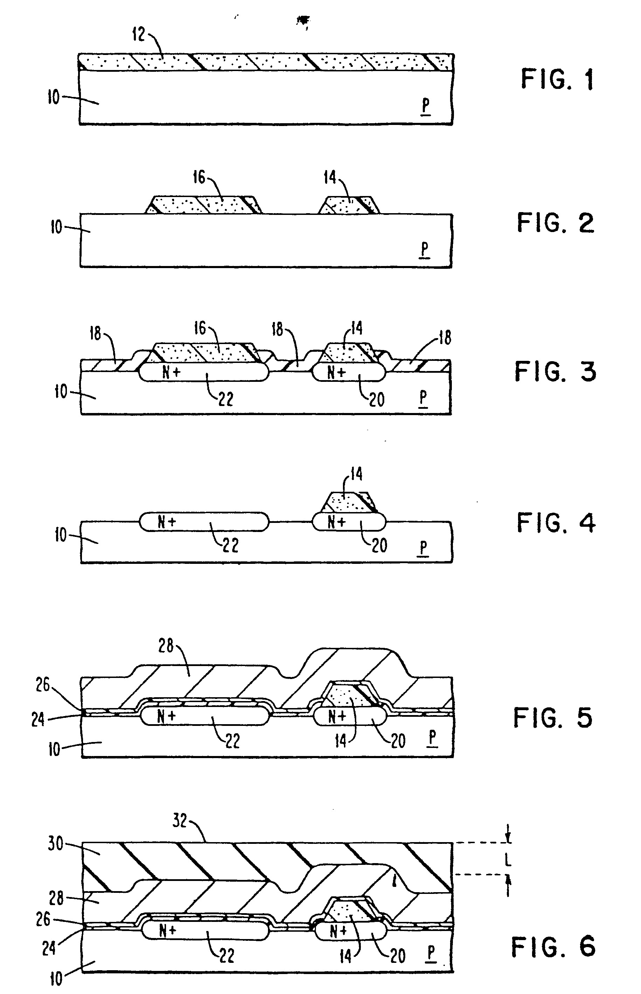

Fig. 6 das Aufbringen der ausgleichenden Photolackschicht auf die in Fig. 5 gezeigte Struktur;

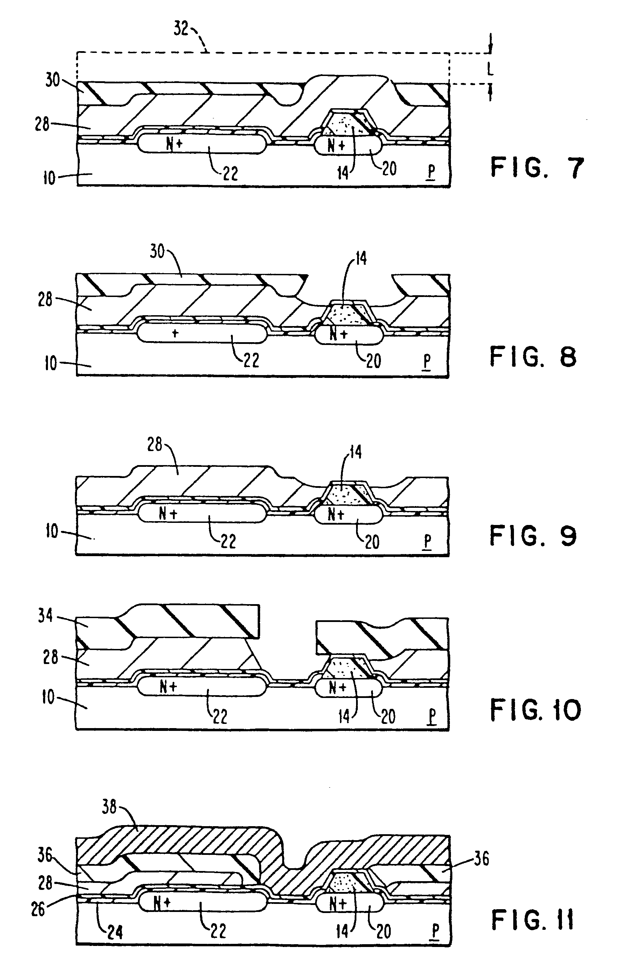

Fig. 7 die Struktur, in der der zu entfernende Teil der leitfähigen Schicht freigelegt ist;

Fig. 8 und 9 die sich nach dem Ätzen der leitfähigen Schicht bzw. nach der Entfernung der Photolackschicht ergebenden Strukturen und

Fig. 10 und 11 die sich zum Abschluss des Verfahrens hin ergebenden Endstrukturen.

Fig. 1 zeigt ein Halbleitersubstrat 10, das vorzugsweise aus P-leitendem Silicium mit einem spezifischen Widerstand von etwa 2 bis 12Ω.cm besteht. Auf dem Substrat 10 ist eine mit 12 bezeichnete Schicht aus einem arsendotierten Oxid aufgebracht. Dazu wurde das Substrat 10 in eine zum chemischen Niederschlag durch Zersetzung aus der Gasphase (CVD) geeignete Atmosphäre aus gasförmigem Silan, Arsin, Sauerstoff und Stickstoff in geeigneten Mengen eingebracht, dass eine dotierte Oxidschicht 12 von etwa 300 bis 500 nm entsteht, die als Diffusionsquellschicht zur Bildung von PN-Übergängen im Substrat dienen kann. Dieser CVD-Prozess wird am besten bei etwa 500°C in einer apparativen Einrichtung ausgeführt, wie sie z.B. in der US-Patentschrift 3 805 736 beschrieben ist.

Ohne dass an dieser Stelle näher darauf einzugehen ist, soll lediglich angemerkt werden, dass die verschiedensten Reinigungs-, Inspektions- und Prüfprozeduren vor bzw. nach den einzelnen, hier hauptsächlich beschriebenen Prozessschritten üblich sind und demzufolge vorgesehen werden können. Solche Reinigungsschritte können dabei beispielsweise aus dem Eintauchen in Säurelösungen und dem Abwaschen unter deionisiertem Wasser mit anschliessendem Reinigen in Gas- oder Luftströmen bestehen, wobei diese Schritte mehr oder weniger von der Produktempfindlichkeit bezüglich der verschiedensten Verunreinigungen abhängig sind. Zusätzlich können auch noch verschiedene zusätzliche Verfahrensschritte in den Prozessablauf eingefügt werden. Beispielsweise kann es bei der Herstellung der in diesem Ausführungsbeispiel beschriebenen dynamischen Speicherschaltungen durchaus wünschenswert sein, eine Getterung der im IBM Technical Disclosure Bulletin, April 1977, Seite 4091, beschriebenen Art vorzusehen, um Leckstrompfade durch Störstellen im Halbleiterkristall zu reduzieren.

Nach dem Aufbringen der dotierten Oxidschicht 12 wird ein photolithographischer Maskierungsschritt durchgeführt, um alle die Bereiche auf der Oberfläche des Substrats 10 zu definieren, in denen diffundierte Übergänge erwünscht sind. Die dotierte Oxidschicht 12 wird dann in einem Nassätzverfahren, beispielsweise in mit Ammoniumfluorid gepufferter Flusssäure, (selektiv) entfernt. Nachdem die schützende Photolackmaskierung ebenfalls entfernt ist, bleiben die mit 14 und 16 bezeichneten Bereiche der dotierten Oxidschicht auf der Oberfläche des Substrats 10 in der in Fig. 2 gezeigten Weise übrig. Obwohl normalerweise eine sehr grosse Anzahl solcher dotierter Bereiche vorgesehen wird, sind zur Beschreibung der Erfindung in diesem Fall nur zwei derartige Bereiche dargestellt. Das mit 14 bezeichnete Gebiet ist in Wirklichkeit ein ausgedehnter Streifen, der sich senkrecht zur Darstellungsebene erstreckt und eine Bit-Abfühlleitung darstellt. Das mit 16 bezeichnete Gebiet ist dabei eines von vielen benachbart zum Gebiet 14 angeordneter Gebiete, die jeweils einen isolierten Kapazitätsbereich bilden.

Im Anschluss an die Abgrenzung der mit 14 und 16 bezeichneten Gebiete wird das Substrat in eine Oxidations-/Eintreibatmosphäre eingebracht, wie sie einrichtungsmässig beispielsweise in der US-Patentschrift 3 790 404 näher beschrieben ist. Dieser Verfahrensschritt wird vorzugsweise bei etwa 1100°C in einer Sauerstoff und etwa 1 bis 3% Wasserstoffchlorid einhaltenden Atmosphäre durchgeführt, wobei sich eine thermische Siliciumdioxidschicht 18 auf der Substratoberfläche bildet, soweit sie nicht von dotierten Oxidschichtbereichen 14 und 16 bedeckt war. Bei diesem Verfahrensschritt erfolgt eine Ausdiffusion von Arsen aus den dotierten Oxidschichtbereichen in das Substrat 10, so dass sich die N+ leitenden Dotierungsgebiete 20 und 22 bilden. Diese aus Fig. 3 ersichtlichen Dotierungsgebiete 20 und 22 repräsentieren dabei die diffundierten Bit-Abfühlleitungen sowie die Speicherknoten einer kapazitiven Ein-FET-Speicherzelle.

Im Anschluss an diesen geschilderten Eintreibschritt wird eine unkritische (nicht gezeigte) Grobmaskierung aufgebracht, die so ausgelegt ist, dass die dotierten Oxidschichtbereiche selektiv über solchen Dotierungsgebieten entfernt werden können, auf die eine kapazitiv angekoppelte überdeckende Schicht aus leitfähigem Material aufgebracht werden muss. Nachdem die Grobmaskierung entfernt ist, wird ein kurzes Eintauchätzen durchgeführt, um jeglichen Rest der thermischen Oxidschicht 18 zu beseitigen, die vorher unter der Grobmaskierung und benachbart zu dem verbleibenden Oxidschichtbereich 14 noch vorhanden war, vgl. insoweit auch die US-Patentschrift 3 975 220. Fig. 4 verdeutlicht das Ergebnis im Anschluss an diesen Verfahrenschritt. Um die effektive Kapazität der Bit-Abfühlleitung gering zu halten, wird das mit 14 bezeichnete Oxidgebiet über dem zugehörigen Dotierungsgebiet 20 für die (diffundierte) Bit-Abfühlleitung aufrechterhalten.

Darauf wird, wie in Fig. 5 illustriert, in einer Sauerstoff/Wasserstoffchlorid enthaltenden Atmosphäre bei etwa 1000°C eine dünne thermische Siliciumdioxidschicht 24 von etwa 30 nm Dicke aufgewaschen. Diese mit 24 bezeichnete Schicht bedeckt dabei die gesamte freigelegte Oberfläche mit Ausnahme der Stellen, an denen dotiertes Oxid vorhanden ist. Dieser Verfahrensschritt kann ebenfalls in einer Einrichtung der in der US-Patentschrift 3 790 404 näher beschriebenen Art ausgeführt werden. Als nächstes wird eine etwa 20 nm dicke Siliciumnitridschicht 26 mittels einer Silan und Ammoniak enthaltenden Atmosphäre bei etwa 900°C aufgebracht. Daran anschliessend erfolgt der Niederschlag einer etwa 300 nm dicken und mit Bor dotierten polykristallinen Siliciumschicht 28 aus einer Wasserstoff, Silan und Borhydrid enthaltenden Atmosphäre bei etwa 600°C. Die beiden letztgenannten Verfahrensschritte können aufeinanderfolgend in einer gemeinsamen Verfahrenskammer der in der US-Patentschrift 3 805 763 näher beschriebenen Art ausgeführt werden.

Wie aus Fig. 5 ersichtlich ist, erstreckt sich die Schicht 28 aus polykristallinem Silicium, die anschliessend als sog. Abschirmschicht abgegrenzt wird, über den dotierten Oxidbereich, der seinerseits die diffundierte Bitleitung 20 bedeckt, und ist kapazitiv damit gekoppelt. Bei den bekannten Verfahren in den US-Patentschriften 3 841 926 sowie 3 975 220 wurde der Aufbau einer Speicherzelle zu diesem Verfahrenszeitpunkt damit abgeschlossen, dass man das polykristalline Silicium der Schicht 28 im Bereich zwischen den Dotierungsgebieten 20 und 22 entfernte, die Schicht 28 anschliessend oxidierte und schliesslich eine Aluminiummetallisierung als Wortleitung über der oxidierten Oberfläche aufbrachte. Die polykristalline Siliciumschicht 28 bleibt bereichsweise erhalten, nämlich über den Dotierungsgebieten 22 für die Speicherknoten, wo sie eine Elektrode des Speicherkondensators der betreffenden Speicherzelle darstellt, bzw. als Abschirmschicht über dem Substrat um die Dotierungsgebiete 22 herum. Weiterhin verblieb die Schicht 28 aber auch über der gesamten Länge der die Bitabfühlleitungen darstellenden Dotierungsgebiete 20, was einen wesentlichen Betrag zur Erhöhung der insoweit wirksamen Koppelkapazität ausmachte. Dieser Effekt trat auf ungeachtet der effektiven Reduzierung der kapazitiven Auswirkungen, die dadurch erreicht wurde, dass man durch Beibehalten der dotierten Oxidbereiche 14 sowohl den Abstand zwischen den Kondensatorelektroden wie auch zwischen den Dotierungsgebieten 20 und der leitfähigen Schicht 28 erhöht hatte.

Im Rahmen der vorliegenden Erfindung werden Bereiche der polykristallinen Siliciumschicht 28 in einem unkritischen Photolithographie- und Ätzverfahren in einer Weise entfernt, dass die effektive Bitleitungskapazität in Speicheranordnungen wesentlich herabgesetzt wird.

Nach dem Niederschlagen der polykristallinen Siliciumschicht 28 wird eine relativ dicke Photolack-Maskierungsschicht 30 auf das Substrat aufgetragen. Die Schicht 30 ist dabei so dick, dass sie alle Bereiche der mit 28 bezeichneten Schicht bedeckt und eine im wesentlichen ebene Oberfläche entsprechend Fig. 6 bildet. Als Photolack für die Schicht 30 kann ein üblicher Positivlack verwendet werden, der unter dem Handelsnamen AZ1350J von der Firma Shipley Company, Newton, Massachusetts vertrieben wird. AZ1350J ist ein lichtempfindliches Polymer, das aus einem m-Kresol-Formaldehyd-Novolak-Harz und einem Diazo-Keton-Sensibilisator, gelöst in Äthylen-Glycol-Monoäthyläther-Azetat besteht. Der Photolack kann einen Zusatz zur Verbesserung der Haftungseigenschaften enthalten, wie z.B. in der US-Patentschrift 3 827 908 beschrieben ist. Das Aufbringen des Photolacks kann in einer der konventionellen Techniken erfolgen, die soviel Material aufzutragen gestattet, dass sich eine im wesentlichen ebene Oberfläche einstellen kann. Anschliessend wird der Photolack mittels einer Wärmebehandlung bei 95°C über eine zum Aushärten ausreichende Zeit behandelt.

Wie in Fig. 7 gezeigt ist, wird als nächstes die Photolackschicht 30 gleichmässig bis zu einer einheitlichen Tiefe L von der ursprünglichen Oberfläche 32 entfernt, um nur die Bereiche der polykristallinen Siliciumschicht 28 freizulegen, die über den beibehaltenen dotierten Oxidgebieten 14 liegen. Die dazu angewendeten Verfahren sind unkritisch, solange die Abtragungsgeschwindigkeit eine Beendigung des Verfahrensschrittes nach Erreichen der Tiefe L gestattet. Auch wird kein Maskierungsschritt benötigt, da vorzugsweise die Photolackschicht von der gesamten Oberfläche einheitlich abgetragen wird, obwohl natürlich auch Grobmaskierungen eingesetzt werden können, um beispielsweise einige erhabene Bereiche der Schicht 28 an gewünschten Stellen stehenzulassen. Als geeignetes Abtragungsverfahren kommen beispielsweise die folgenden Möglichkeiten in Betracht: durchgehende Belichtung der Photolackschicht 30 bis zu einer Tiefe L, so dass ein Standard-Entwickler zur Entfernung der belichteten Schichtbereiche angewendet werden kann.

Durchgehende einheitliche Belichtung des Photolacks durch ein neutrales Dichtefilter, um die Entwicklungsrate ausreichend zur Steuerung der Entwicklungstiefe L herabzusetzen, vgl. z.B. US-Patentschrift 3 649 393. Gleichmässiges Abtragen der nicht belichteten Photolackschicht 28 mittels eines aus einem Lösungsmittel bestehenden Entwicklers, z.B. einer Kaliumpermanganat enthaltenden Phosphorsäure, vgl. US-Patentschrift 4 089 766. Schliesslich kommt noch ein Abtrag mittels reaktiven Ionenätzens bzw. mittels eines Sputterverfahrens in Betracht. Da eine gleichmässige Photolackschicht abgetragen wird, ist dieser Verfahrensschritt selbstjustierend und legt selektiv lediglich die Bereiche des beschichteten Substrats frei, die in der in Fig. 7 gezeigten Weise durch die verbleibende Photolack-Maskierungsschicht reichen.

Nach dem Entfernen eines Teils der Photolackschicht 30 wird das dann freiliegende polykristalline Silicium selektiv mittels eines geeigneten Ätzmittels entfernt, z.B. mittels einer Lösung aus Salpetersäure, Wasser und gepufferter Flusssäure in einem Volumenverhältnis von 7:4:1, wobei die gepufferte Flusssäure 5 Volumenteile 40%igen Ammoniumfluorids auf einen Volumenteil 48%iger Flusssäure aufweist. Durch diesen Verfahrensschritt wird in wirksamer Weise im wesentlichen alles Material der polykristallinen Siliciumschicht 28 über den Dotierungsgebieten 20 für die Bit-Abfühlleitungen abgetragen. Die mögliche parasitäre Koppelkapazität zwischen den relativ langgestreckten Bit-Abfühlleitungen und den benachbart dazu liegenden Bereichen der leitfähigen Schicht 28 wird dadurch erheblich verringert.

Im Anschluss an das selbstausrichtende Ätzen der Schicht 28 werden die verbleibenden Bereiche der Photolackschicht 30 mittels konventioneller Ablöseverfahren entfernt, z.B. mit N-Methylpyrolidon. Aus Fig. 9 ist ersichtlich, dass im Anschluss an den geschilderten Verfahrensschritt eine Anordnung verbleibt, die hinsichtlich des Verfahrenszustandes mit Fig. 5 vergleichbar ist. Demgegenüber besteht jedoch der Unterschied, dass die leitfähige Schicht 28 aus polykristallinem Silicium von selektiven Bereichen, insbesondere über den Dotierungsgebieten 20 für die Bit-Abfühlleitungen mit den darüber belassenen dotierten Oxidgebieten 14, entfernt worden ist.

Für den weiteren Verfahrensablauf kann entsprechend der US-Patentschrift 3 841 926 in der folgenden Weise vorgegangen werden. Nach dem Ablösen der selbstausrichtenden Photolackschicht 30 wird ein weiterer Photolithographie- und Ätzschritt angewandt, um die Bereiche der polykristallinen Siliciumschicht 28 zu ätzen, an denen Gate-Bereiche für die jeweiligen Feldeffekttransistoren erforderlich sind, vgl. Fig. 10. Obwohl man aufgrund der Darstellung in den Figuren annehmen könnte, dass durch diesen Verfahrensschritt die zuvor geätzten Bereiche der Schicht 28 ausgedehnt würden, ist dieser Ätzschritt jedoch auf relativ kleine Gate- Bereiche beschränkt, wodurch jeder der zahlreichen isolierten Bereiche 22 der Speicherknoten mit dem langgestreckten Dotierungsgebiet 20 der zugehörigen Bitleitung gekoppelt wird. Eine geringe Fehljustierung der zum Ätzen der Gatebereiche erforderlichen Photolackmaske 34 wird im wesentlichen nicht die Kapazität der Bit-Abfühlleitungen beeinflussen, während eine Fehljustierung bei der zur Entfernung des polykristallinen Siliciums 28 benutzten Maskierung für den dotierten Oxidbereichen 14 unannehmbar grosse Kapazitätsänderungen der Bitleitungen von Chip zu Chip zur Folge haben würde, wobei die so hergestellten Speicheranordnungen entsprechend unterschiedliche Betriebseigenschaften zeigen würden.

Im Anschluss an die Abgrenzung der Gate-Bereiche werden die verbleibenden Bereiche der polykristallinen Siliciumschicht 28 in einer Sauerstoff/Wasserstoffchlorid-Atmosphäre bei etwa 1000°C thermisch oxidiert, wobei die mit 36 bezeichnete Siliciumdioxidschicht entsteht. Durch diesen Oxidationsschritt wird das Ausmass der kapazitiven Kopplung zwischen der Schicht 28 aus polykristallinem Silicium und dem Dotierungsgebiet 20 für die Bit-Abfühlleitung, wie aus Fig. 11 ersichtlich, weiter vermindert, da die Oxidation sowohl die Dicke als auch die seitliche Abmessung der Schicht 28 reduziert.

Zur Bildung der Gate-Elektroden und elektrisch leitfähigen Wortleitungen wird abschliessend eine leitfähige Schicht 38, z.B. aus Kupfer-Aluminium im Rahmen eines sog. Lift-off-Prozesses aufgedampft. Obwohl im Rahmen der Herstellung solcher Speicheranordnungen noch zusätzliche Passivierungs- und Leitschichten vorzusehen sein werden, sind nach dem Aufbringen der Aluminiumschicht 38 die eigentlichen Speicherzellen, die aus den Dotierungsgebieten 20 für die Bit-Abfühlleitungen, den Gate-Elektroden 38, und den Speicherknoten 22 sowie Kondensatorelektroden (Bereiche der Schicht 28 über den Dotierungsgebieten 22) bestehen, voll funktionsfähig und testbar. Die elektrische Isolierung benachbarter Speicherknoten 22 ist möglich, indem man ein Referenzpotential an die polykristalline Siliciumschicht 28 anlegt, so dass die Oberfläche des Substrats 10 benachbart zu den Gebieten 20 und 22, jedoch nicht unter den Elektroden 38 zwischen diesen Gebieten, dauernd in Sperrichtung vorgespannt ist. Dies kann erreicht werden, indem man das Substrat 10 und die Schicht 28 aus polykristallinem Silicium an eine negative Spannung anlegt.

Obwohl die Erfindung im Zusammenhang mit einem bevorzugten Ausführungsbeispiel erläutert wurde, ist festzuhalten, dass solche Oberflächenunregelmässigkeiten, wie die erhabenen Bereiche der Schicht 28 im vorliegenden Ausführungsbeispiel, durch die oben anhand der Fig. 6 bis 9 verdeutlichten Verfahrensschritte planarisiert werden können. Die hauptsächlichen Verfahrensschritte sind, dass die derart unebene Oberfläche mit einer Maskierungsschicht, z.B aus Photolack, bedeckt wird, dass von der neuentstandenen ebenen Oberfläche ein gleichmässiger Oberflächenanteil der Maskierungsschicht so abgetragen wird, dass die Oberflächen der erhöhten Bereiche darunter freigelegt werden, und anschliessend zunächst diese freigelegten Bereiche sowie daraufhin die verbleibenden Maskierungsschichtteile entfernt werden.

## Patentansprüche

1. Verfahren zur Herstellung von Halbleiteranordnungen mit herabgesetzter kapazitiver Kopplung zwischen mindestens einem in einem Halbleitersubstrat (10) angeordneten Dotierungsgebiet (20) und einer isoliert auf dem Substrat vorgesehenen elektrisch leitfähigen Schicht (28), die über dem Dotierungsgebiet (20) einen grösseren Abstand von der Substratoberfläche als ausserhalb des Dotierungsgebiets und somit eine unebene Oberfläche mit mindestens einem erhabenen Bereich aufweist (Fig. 5), dadurch gekennzeichnet, dass auf die Oberfläche der leitfähigen Schicht (28) eine diese vollständig bedeckende Maskierungsschicht (30) aufgebracht wird, die ihrerseits eine praktisch ebene Oberfläche (32) bildet (Fig. 6), dass von der Maskierungsschicht (30) ein einheitlicher Schichtdickenanteil (L) abgetragen wird, bis die Oberfläche des mindestens einen erhabenen Bereichs der leitfähigen Schicht (28) über dem (den) Dotierungsgebiet(en) (20) freigelegt ist (Fig. 7) und dass anschliessend die leitfähige Schicht (28) in dem (den) derart freigelegten Bereich(en) abgetragen wird (Fig. 8).

2. Verfahren nach Anspruch 1, gekennzeichnet durch eine Maskierungsschicht (30) aus einem organischen Polymer, vorzugsweise einem strahlungsempfindlichen Polymer.

3. Verfahren nach den Ansprüchen 1 oder 2, dadurch gekennzeichnet, dass zum Abtragen des einheitlichen Schichtdickenanteils (L) der Maskierungsschicht (30) eine Tiefenbelichtung bis zu einer Tiefe vorgenommen wird, die grösser ist als der Abstand zwischen der Oberfläche (32) der Maskierungsschicht (28) und dem (den) obersten erhabenen Oberflächenbereich (en) der leitfähigen Schicht (28) und dass anschliessend zur bereichsweisen Freilegung der leitfähigen Schicht (28) die belichteten Schichtanteile der Maskierungsschicht (30) durch Anwendung eines chemischen Entwicklungsverfahrens entfernt werden.

4. Verfahren nach den Ansprüchen 1 oder 2, dadurch gekennzeichnet, dass zum Abtragen des einheitlichen Schichtdickenanteils (L) der Maskierungsschicht (30) ein Ätzverfahren, vorzugsweise in Form eines reaktiven Ionenätzverfahrens, durchgeführt wird.

5. Verfahren nach mindestens einem der vorhergehenden Ansprüche, dadurch gekennzeichnet, dass die leitfähige Schicht (28) aus polykristallinem Silicium besteht, unter dem sich im Bereich wenigstens eines im Substrat (10) angeordneten Dotierungsgebiets (20) ein Dielektrikum enthaltend ein dotiertes Oxidgebiet (14) befindet, aus dem als Quellschicht das Dotierungsgebiet (20) durch Ausdiffusion hergestellt wurde.

6. Verfahren nach Anspruch 5, dadurch gekennzeichnet, dass im Substrat weitere Dotierungsgebiete (22) vorgesehen sind, die von der leitfähigen Schicht (28) durch ein, verglichen mit der Dicke eines dotierten Oxidgebiets (14), relativ dünnes Dielektrikum (24, 26) getrennt sind.

7. Verfahren nach mindestens einem der vorhergehenden Ansprüche, dadurch gekennzeichnet, dass damit Halbleiteranordnungen für Speicherbauelemente, insbesondere für kapazitive Ein-FET-Speicherzellen, hergestellt werden, bei denen jeweils ein im Substrat (10) angeordnetes Dotierungsgebiet (20) die mit möglichst geringer kapazitiver Kopplung zur leitfähigen Schicht (28) auszulegende Bit-Abfühlleitung und ein weiteres dazu benachbartes Dotierungsgebiet (22) den jeweiligen kapazitiven Speicherknotenbereich mit demgegenüber hoher Kopplungskapazität darstellt.

## Claims

1. Method of making semiconductor devices with reduced capacitive coupling between at least one doping region (20) arranged in a semiconductor substrate (10), and an electrically conductive layer (28) which is provided isolated on the substrate, which over the doping region (20) is spaced farther from the substrate surface than away from the doping region, and which thus has a non-planar surface with at least one raised portion (Fig. 5), characterized in that onto the surface of the conductive layer (28) a masking layer (30) fully covering the latter is applied which forms a substantially planar surface (32) (Fig. 6), that from the masking layer (30) a uniform layer thickness portion (L) is removed until the surface of the at least one raised portion of the conductive layer (28) over the doping region(s) (20) is bared (Fig. 7), and that subsequently the conductive layer (28) in the thus bared region(s) is removed (Fig. 8).

2. Method as claimed in claim 1, characterized by a masking layer (30) of an organic polymer, preferably a photosensitive polymer.

3. Method as claimed in claims 1 or 2, characterized in that for removing the uniform layer thickness portion (L) of the masking layer (30) a depthwise exposure is effected to a depth greater than the distance between the surface (32) of the masking layer (28) and the top raised surface region(s) of the conductive layer (28), and that subsequently for the region-wise baring of the conductive layer (28) the exposed layer portions of the masking layer (30) are removed using a chemical developing process.

4. Method as claimed in claims 1 or 2, characterized in that for removing the uniform layer thickness portion (L) of the masking layer (30) an etching process is effected, preferably in the form of a reactive ion etching.

5. Method as claimed in any one of the preceding claims, characterized in that the conductive layer (28) consists of polycrystalline silicon beneath which in the area of at least one doping region (20) arranged in the substrate (10), a dielectric layer comprising a doped oxide region (14) is provided out from which the doping region (20) has been diffused.

6. Method as claimed in claim 5, characterized in that in the substrate further doping regions (22) are provided which are spaced from the conductive layer (28) by a dielectric layer (24, 26) which is relatively thin compared with the thickness of a doped oxide region (14).

7. Method as claimed in any one of the preceding claims, characterized in that semiconductor devices for storage components, particularly for capacitive one-FET memory cells are made therewith, where one respective doping region (20) arranged in the substrate (10) represents a bit sensing line to be designed with a minimum capacitive coupling to the conductive layer (28) and where another adjacent doping region (22) represents a respective capacitive memory node region with a comparatively high coupling capacitance.

## Revendications

1. Procédé pour fabriquer des dispositifs semi-conducteurs à couplage capacitif réduit, entre au moins une région de dopage (20) disposée dans un substrat semi-conducteur (10) et une couche électriquement conductrice (28) isolée du substrat; ladite couche ayant au-dessus de la région de dopage (20) un éloignement plus grand de la surface du substrat qu'en dehors de la région de dopage, et formant ainsi une surface non plane comportant au moins une région saillante (figure 5); ce procédé est caractérisé en ce que l'on dépose sur la surface de la couche conductrice (28) une couche de masquage (30) recouvrant celle-ci complétement, ladite couche de masquage formant à son tour une surface pratiquement plane (32) (figure 6); en ce que l'on enlève de la couche de masquage (30) une partie uniforme (L) de l'épaisseur de couche jusqu'à ce que la surface, comportant au moins une région saillante de la couche conductrice (28) au-dessus de la région (ou des régions) de dopage (20), soit exposée (figure 7); et en ce qu'on enlève ensuite la couche conductrice (28) dans la (ou les) région(s) ainsi exposée(s) (figure 8).

2. Procédé selon la revendication 1, caractérisé en ce que la couche de masquage (30) est constituée par un polymère organique, de préférence un polymère sensible aux radiations.

3. Procédé selon la revendication 1 ou 2, caractérisé en ce que, pour enlever la partie uniforme (L) de l'épaisseur de la couche de masquage (30), on procède à une exposition en profondeur jusqu'à une profondeur qui est plus grande que la distance entre la surface (32) de la couche de masquage (30) et la (ou les) région(s) de surface saillante supérieure de la couche conductrice (28), et en ce qu'on enlève ensuite, par application d'un procédé de développement chimique, la partie exposée de la couche de masquage (30) pour exposer la couche conductrice (28), région par région.

4. Procédé selon la revendication 1 ou 2, caractérisé en ce qu'on utilise un procédé de décapage, de préférence un procédé de décapage par ions réactifs, pour enlever la partie uniforme (L) de l'épaisseur de la couche de masquage (30).

5. Procédé selon au moins une des revendications précédentes, caractérisé en ce que la couche conductrice (28) est constituée par une couche de silicium polycristallin sous laquelle est située une couche diélectrique comportant une région d'oxyde dopé (14) dans la zone d'au moins une région de dopage (20) disposée dans le substrat (10); la région de dopage (20) étant obtenue par diffusion à partir de cette région d'oxyde dopée (14).

6. Procédé selon la revendication 5, caractérisé en ce qu'il est prévu dans le substrat d'autres régions de dopage (22) qui sont isolées de la couche conductrice (28) par une couche diélectrique (24, 26) relativement mince par rapport à l'épaisseur d'une région d'oxyde dopé (14).

7. Procédé selon au moins une des revendications précédentes, caractérisé en ce qu'il permet de fabriquer des dispositifs semi-conducteurs pour des éléments de mémoire, en particulier pour des cellules de mémoire de type capacitif à un seul transistor FET, dans lesquels une région de dopage (20) disposée dans le substrat (10) représente la ligne de détection de bit qui doit présenter, un couplage capacitif aussi réduit que possible avec la couche conductrice (28), et dans lesquels une autre région de dopage (22), adjacente, représente la région capacitive formant noeud de mémoire à capacité de couplage élevée.

FIG. 1

FIG. 2

FIG. 3

FIG. 4

FIG. 5

FIG. 6

FIG. 7

FIG. 8

FIG. 9

FIG. 10

FIG. 11